# EUROPÄISCHE PATENTSCHRIFT

(11) **EP 1 062 730 B1**
(45) Veröffentlichungstag und Bekanntmachung des Hinweises auf die Patenterteilung: **15.05.2002**
(21) Anmeldenummer: 99916754.7
(22) Anmeldetag: 18.02.1999
(51) Int. Cl.: H03M 1/66, H03H 17/06, G06J 1/00, G11B 20/10

(54) **VORRICHTUNG ZUR SIGNALVERARBEITUNG VON ZEITDISKRETEN WERTEN**
DEVICE FOR SIGNAL-PROCESSING IN TIME DISCRETE VALUES
DISPOSITIF DE TRAITEMENT DE SIGNAUX DE VALEURS DE NATURE DISCRETE DANS LE TEMPS

(30) Priorität: 07.03.1998 DE 19809882
(43) Veröffentlichungstag der Anmeldung: 27.12.2000
(73) Patentinhaber: GTE Gesellschaft für technische Entwicklungen GmbH, 74653 Ingelfingen-Lipfersberg (DE)
(72) Erfinder: WEIGEL, Ralf, D-74653 Künzelsau (DE)
(74) Vertreter: Clemens, Gerhard, Dr.-Ing.
(86) Internationale Anmeldenummer: DE9900507
(87) Internationale Veröffentlichungsnummer: WO9945651

(56) Entgegenhaltungen:
- US-A- 5 521 946

## Beschreibung

### TECHNISCHES GEBIET

Die vorstehende Erfindung betrifft eine Vorrichtung zur Signalverarbeitung von zeitdiskreten Werten für signalabtastende Systeme mit Mitteln wie Digital Analog Wandlern, Switched-Capacitor Filtern, Direkt Digital Synthesizern, Sample- and Hold-Schaltungen und dergleichen, die ein analoges zeitdiskretes Ausgangssignal liefern, mit Mitteln zum Erzeugen zeitdiskreter Werte, die den Mitteln zugeführt werden, die ein analoges zeitdiskretes Ausgangssignal liefern, zumindest einer Gruppe von zumindest zwei parallel geschalteten signalabtastenden Mitteln, Mitteln zum Erzeugen von Abtastsignalen gleicher Frequenz, Summationsmitteln, die die Ausgangssignale der signalabtastenden Mittel aufsummieren.

### STAND DER TECHNIK

Es ist bekannt, daß abtastende Systeme nur zu bestimmten Zeiten bestimmte Werte ausgeben können. Das bedeutet, daß das Ausgangssignal eines solchen Systems einer Treppe ähnelt und somit neben der Nutzinformation auch spektrale Anteile der Abtastfrequenz enthält. Diese Spektralanteile werden durch ein zeitkontinuierliches Filter unterdrückt, damit keine Faltungsprodukte aus dem Nutzsignal und der Abtastfrequenz entstehen.

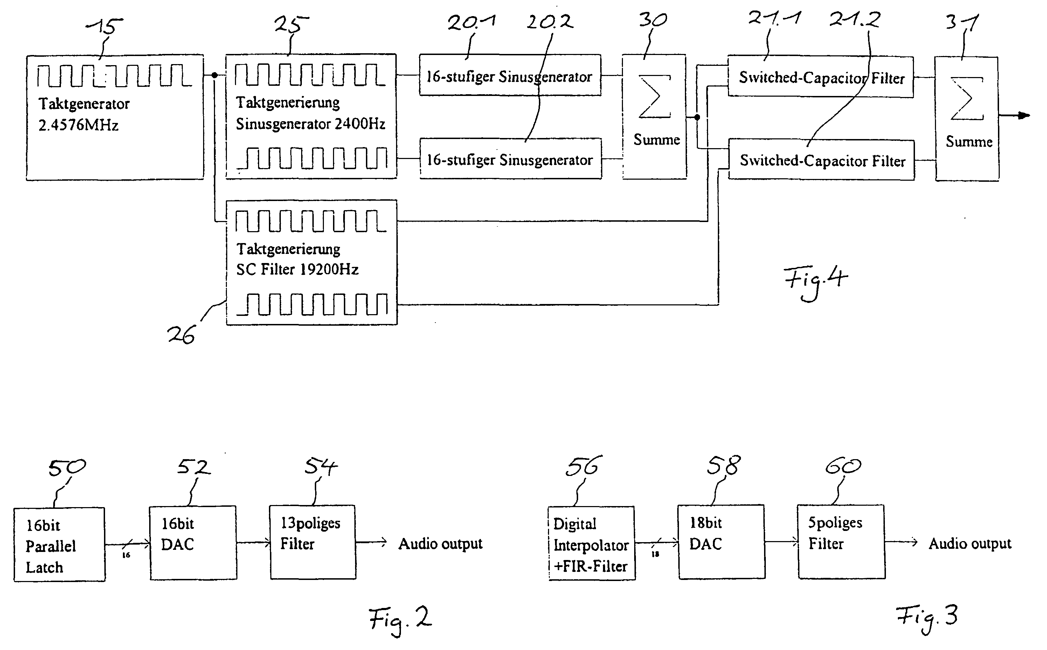

Bei bekannten Digital-Analog(DA)Wandlern treten Probleme. auf. Anhand eines Compact Disc(CD)-Spielers läßt sich diese Problematik gut erläutern. Das vereinfachte Blockdiagramm der Wiedergabeelektronik eines CD-Spielers der ersten Generation ist in Fig. 2 dargestellt. Die Wiedergabeelektronik 50 liefert einen digitalen Datenstrom mit 16 Bit pro Takt. Die Abtastfrequenz ist 44,1 kHz. Da das Audioband von 20 Hz bis 20 kHz reicht, ist es laut dem Abtasttheorem möglich, die ursprüngliche Information mittels eines Digital Analog Wandlers 52, der mit 44,1 kHz getaktet wird, und mittels eines nachfolgenden analogen Antialisingfilters 54, der Faltungsprodukte unterdrückt, wieder herzustellen. Dieses Filter 54 hat zwei grundsätzliche Anforderungen zu erfüllen. Es muß einen glatten Frequenzgang im nutzbaren Bereich aufweisen und es muß eine Dämpfung von mehr als 60 dB bei der halben Abtastrate von 22,05 kHz aufweisen, um unerwünschte Alisingprodukte zu unterdrücken. Derartige Anforderungen werden nur mittels komplizierter Filter 54 13. Ordnung erreicht.

Ein anderer Ausweg eröffnete sich mit der Verbesserung der DA Wandlertechnologie. Die zweite Generation nutzte eine Oversamplingrate von 2-fach bis 4-fach. Fig. 3 zeigt schematisch in einem Blockdiagramm die Wiedergabeelektronik von CD-Spielern der zweiten Generation. Dazu wurden in speziellen digitalen Filtern innerhalb der Wiedergabeelektronik 56 - sogenannte FIR-Filter (Finite Impuls Response Filter) - Zwischenwerte berechnet und zusätzlich an den DA Wandler 58 ausgegeben. Dieses erhöhte die Abtastrate von 44,1 kHz auf 88,2 kHz bzw. 176,4 kHz. Doch neben der erhöhten Abtastfrequenz mußte der DA Wandler 58 auch noch genauer sein, nämlich 20 Bit. Das ist eigentlich eine gegensätzliche Forderung, genauer und schneller. Der Vorteil, der sich mit dieser kostenintensiven Lösung erkauft wurde, ist die Vereinfachung des analogen Filter, denn die 60 dB Dämpfung muß erst bei der halben Taktrate 44,1 kHz bzw. 88,2 kHz erreicht werden. Bei einer 4-fachen Überabtastung verringert sich die Zahl der notwendigen Pole im Filter 60 auf 5. Bei der heutzutage möglichen 16-fachen Übertastung reichen schon Filter zweiter Ordnung aus.

Switched-Capacitor Filter sind ebenfalls abtastende Systeme, so daß hier die gleichen Probleme auftreten. Aktive zeitkontinuierliche Filter benötigen neben dem aktiven Element (z.B. Operationsverstärker) Widerstände und Kondensatoren. Bei den Switched-Capacitor Filtern werden die Widerstände durch geschaltete Kondensatoren ersetzt. Zwischen der Schaltfrequenz und dem äquivalenten Leitwert besteht ein linearer Zusammenhang. Typische Abtastfrequenzen integrierter SC-Filter liegen bei der 50- bis 100-fachen Eckfrequenz. Das bedeutet, daß sich das Ausgangssignal aus 50 bis 100 analogen zeitdiskreten Werten zusammensetzt. Dieser treppenförmige Verlauf enthält also auch Spektralanteile der Schaltfrequenz. Diese sind durch ein nachfolgendes Filter zu unterdrücken. Wenn man diese Filter mittels Veränderung der Abtastfrequenz durchstimmbar gestalten möchte, kann man also einen Bereich von zwei Dekaden realisieren. Wenn man z.B. ein über den Audiobereich gehendes Tiefpaßfilter realisieren möchte, so erstreckt sich der durchzustimmende Bereich über drei Dekaden von 20 Hz bis 20 kHz. Das würde bedeuten, man müßte das analoge Glättungsfilter ebenfalls durchstimmbar oder umschaltbar gestalten, denn bei einer Eckfrequenz dieses Filters von 20 Hz generiert dieses Filter systembedingt eine Frequenzkomponente von 2 kHz mit einer Amplitude von rund -40 dB (1/100) unter dem Nutzsignal.

Weiterer Stand der Technik zu DA-Wandlern und SC-Filtern ist folgenden Veröffentlichungen zu entnehmen:
- Paul Horowitz, The Art of Electronics, Cambridge University Press, Cambridge 1990,
- Robert Adams, DAC ICs: How Many Bits is Enough?, Sound and Video Contractor, February 20, 1991, Seite 8-189 bis 8-192,
- Larry Gaddy and Hajima Kawai, DYNAMIC PERFORMANCE TESTING OF DIGITAL AUDIO D/A CONVERTERS, APPLICATION BULLETIN, Burr-Brown Corporation, 1997,
- Helmuth Lemme, Filtern ohne zu rechnen, Elektronik 11/1997 Seite 96 bis 104,
- Internetadresse: http: //www.km.philips.com/osc/cdrom/geninfo/geninf_1.htm1, 11/4/97, page 1 bis 18,
- Nav S. Sooch et al, 18-BIT STEREO D/A CONVERTER WITH INTE-GRATED DIGITAL AND ANALOG FILTERS, Sooch CS4328 AES Paper, New York, October 1991,
- Digital-to-Analog Converter with Low Intersample Transistion Distortion and Low Sensitivity to Sample Jitter and Transresistance Amplifier Slew Rate in der Audio Engineering Society, Vol. 42, No. 11, 1994 November,
- Kapitel 6.11 Glitchless DACs in dem Buch Analog-to-Digital and Digital-to-Analog Conversion Techniques von David F. Hoeschele Second Edition Wiley-Interscience 1994 ISBN 0-471-57147-4.

In der US-A-5,521,946 ist eine Vorrichtung zur Signalverarbeitung von zeitdiskreten Werten der eingangs genannten Art bekannt. Bei dieser Vorrichtung sind mehrere DA-Wandler parallel geschaltet, die mit unterschiedlichen Werten beaufschlagt werden. Gleiche Eingangssignale werden unterschiedlichen Digitalfiltern zugeführt, die wiederum unterschiedliche digitale Ausgangswerte erzeugen, die die unterschiedlichen Eingangssignale für die DA-Wandler darstellen. Nach der Umwandlung in analoge Signale wird die Summation im analogen Bereich durchgeführt.

### DARSTELLUNG DER ERFINDUNG

Der vorliegenden Erfindung liegt die Aufgabe bzw. das technische Problem zugrunde, ausgehend von dem genannten Stand der Technik, eine Vorrichtung zur Signalverarbeitung von zeitdiskreten Werten der eingangs genannten Art anzugeben, die es ermöglicht, eine Erhöhung der Anzahl von Zwischenwerten bei abtastenden Systemen zu erzeugen, ohne die Genauigkeit oder die Abtastrate des abtastenden Systems zu verändern.

Die erfindungsgemäße Vorrichtung ist durch die Merkmale des unabhängigen Anspruchs 1 gegeben. Vorteilhafte Ausgestaltungen und Weiterbildungen sind Gegenstand der abhängigen Ansprüche.

Die erfindungsgemäße Vorrichtung zur Signalverarbeitung von zeitdiskreten Werten zeichnet sich demgemäß dadurch aus, daß bei der zumindest einen Gruppe von zumindest zwei signalabtastenden parallel geschalteten Mitteln jeweils eine Signalabtastung des betragsmäßig gleichen Eingangssignals durchgeführt wird und das jeweilige abtastende Mittel mit versetzter Phasenlage der Abtastsignale von den Mitteln zum Erzeugen von Abtastsignalen gleicher Frequenz angesteuert wird, wodurch zu jedem Eingangssignal mehrere entsprechend der Anzahl der parallel geschalteten signalabtastenden Mittel gleiche aber phasenversetzte analoge Ausgangssignale erzeugt werden, die durch ihre Summation eine Interpolation im analogen Bereich darstellen.

Eine besonders bevorzugte Ausgestaltung zeichnet sich dadurch aus, daß die Anzahl der parallel geschalteten abtastenden Mittel der Anzahl der erzeugten Frequenzen mit versetzter Phasenlage entspricht.

Eine besonders bevorzugte Ausgestaltung der erfindungsgemäßen Vorrichtung zeichnet sich dadurch aus, daß die Phasenunterschiede der Abtastfrequenzen mit versetzter Phasenlage gleich ausgebildet sind, das heißt, dass n Abtastsignale um je 360°/n phasenverschoben erzeugt werden, wobei n der Anzahl der parallel geschalteten abtastenden Mittel entspricht, das heißt eine lineare Interpolation möglich ist.

Eine alternative Ausgestaltung zeichnet sich dadurch aus, daß bei Abtastsignalen gleicher Frequenz die Phasenunterschiede der Abtastfrequenzen mit versetzter Phasenlage unterschiedlich ausgebildet sind. Dadurch läßt sich eine nicht lineare Interpolation umsetzen, die beispielsweise ermöglicht, daß Bereiche mit besonders hoher Genauigkeit oder sonstige beispielsweise singuläre Bereiche zuverlässig abgebildet werden können.

Eine vorteilhafte Weiterbildung ist dadurch gekennzeichnet, daß die mit unterschiedlicher Phasenlage abtastenden Mittel in zwei Gruppen aufgeteilt werden, die jeweils mit dem nichtinvertierten und dem invertierten Eingangssignal beaufschlagt werden, wobei die Mittel zum Summieren die nichtinvertierten Signale aufsummiert und invertierten Signale abzieht.

Eine besonders bevorzugte Weiterbildung zeichnet sich dadurch aus, daß zumindest zwei abtastende Mittel gleich ausgebildet sind.

Eine besonders vorteilhafte Ausgestaltung zeichnet sich dadurch aus, daß mehrere Gruppen von abzutastenden Systemen vorhanden sind, wobei jede Gruppe mit unterschiedlichen Abtastfrequenzen mit versetzter Phasenlage angesteuert wird. Dadurch kann die Weiterverarbeitung der Signale alternativ bevorzugt so ausgestaltet werden, daß die Signale der mehreren Gruppen von abtastenden Mitteln einem Mittel zum Aufsummieren zugeführt werden oder bevorzugt so ausgestaltet werden, daß die aufsummierten Signale der ersten Gruppe von abtastenden Mitteln einer zweiten Gruppe von abtastenden Mitteln zugeführt werden, die wiederum mit Abtastfrequenzen mit versetzter Phasenlage angesteuert werden und deren Signale weiteren Mitteln zum Auf summieren zugeführt werden.

Eine weitere bevorzugte Ausgestaltung der erfindungsgemäßen Vorrichtung zeichnet sich dadurch aus, daß mehrere Gruppen von abzutastenden Mitteln vorhanden sind, wobei jede Gruppe mit gleichen Abtastfrequenzen mit versetzter Phasenlage angesteuert wird.

Weitere Ausführungsformen und Vorteile der Erfindung ergeben sich durch die in den Ansprüchen ferner aufgeführten Merkmale sowie durch die nachstehend angegebenen Ausführungsbeispiele. Die Merkmale der Ansprüche können in beliebiger Weise miteinander kombiniert werden, insoweit sie sich nicht offensichtlich gegenseitig ausschließen.

### KURZE BESCHREIBUNG DER ZEICHNUNG

Die Erfindung sowie vorteilhafte Ausführungsformen und Weiterbildungen derselben werden im folgenden anhand der in der Zeichnung dargestellten Beispiele näher beschrieben und erläutert. Die der Beschreibung und der Zeichnung zu entnehmenden Merkmale können einzeln für sich oder zu mehreren in beliebiger Kombination erfindungsgemäß angewandt werden. Es zeigen:
- Fig. 1: schematische ausschnittsweise Darstellung einer Vorrichtung mit vier abtastenden Mitteln, die mit phasenweise versetzt angeordneten Frequenzen angesteuert werden, zum Generieren eines Dreiecksspannungsverlaufs,
- Fig. 2: vereinfachtes Blockdiagramm der Wiedergabeelektronik eines bekannten CD-Spielers der ersten Generation,
- Fig. 3: vereinfachtes Blockdiagramm der Wiedergabeelektronik eines bekannten CD-Spielers der zweiten Generation,
- Fig. 4: schematisches Blockdiagramm einer Vorrichtung mit zwei digitalen Sinusgeneratoren und zwei Switched-Capacitor Filtern,
- Fig. 5: Diagramm der bei der Vorrichtung nach Fig. 4 generierten beiden 16-stufigen Sinusschwingungen und deren Aufsummation zu einer 32-stufigen Sinusschwingung,
- Fig. 6: Spektralanalyse der 16-stufigen Sinusschwingung gemäß Fig. 5,
- Fig. 7: Spektralanalyse der 32-stufigen Sinusschwingung gemäß Fig. 5,
- Fig. 8: Sinusschwingung bei zusätzlichem Einsatz eines Switched-Capacitor Filters,
- Fig. 9: Spektralanalysediagramm der Sinusschwingung gemäß Fig. 8,
- Fig. 10: Sinusschwingung bei zusätzlichem Einsatz von zwei Switched-Capacitor Filtern,
- Fig. 11: Spektralanalysediagramm der Sinusschwingung gemäß Fig. 10,
- Fig. 12: schematische Detaildarstellung einer Vorrichtung mit zehn parallel geschalteten Switched-Capacitor Filtern mit teilweise invertierten Eingangssignalen,
- Fig. 13, 14, 15: schematische Darstellung einer Vorrichtung mit unterschiedlich geschalteten Gruppen von parallelen Systemen und
- Fig. 16: schematisches ausschnittsweises Schaltbild der Vorrichtung gemäß Fig. 4.

### WEGE ZUM AUSFÜHREN DER ERFINDUNG

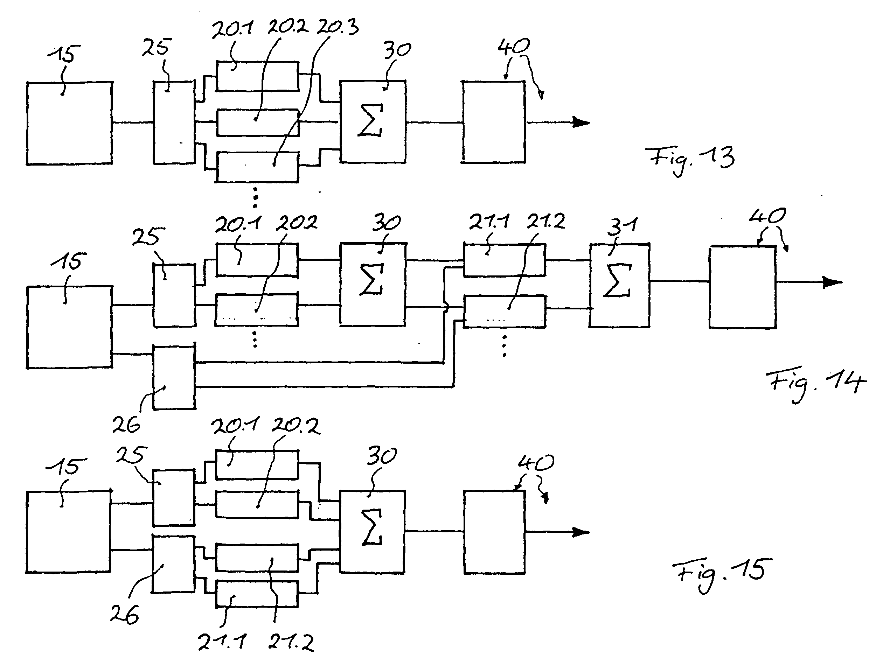

In Fig. 13 ist schematisch ausschnittsweise ein Blockdiagramm für eine Vorrichtung zur Signalverarbeitung von zeitdiskreten Werten dargestellt, wie sie beispielsweise innerhalb eines Audiosystems verwendet werden kann. Es ist ein Taktgenerator 15 vorhanden, der den sogenannten Mastertakt zur Verfügung stellt. Dem Generator 15 sind Mittel 25 zum Generieren von Takten nachgeschaltet, welche wiederum nachfolgend parallel geschaltete abtastende Systeme 20.1, 20.2, 20.3 etc. mit ihren Ausgangssignalen beaufschlagen. Die Ausgangssignale der abtastenden Mittel 20 werden Mittel 30 zum Aufsummieren zugeführt und das aufsummierte Signal wiederum wird Mitteln 40 zum Weiterver-/bearbeiten der Signale zugeführt, wobei diese Mittel beispielsweise in einem handelsüblichen analogen Filter bestehen können, der Frequenzen im Bereich über 20 kHz unterdrückt.

Die Mittel 25 zum Erzeugen von Abtastfrequenzen erzeugen für jedes nachfolgende parallel geschaltete Abtastsystem eine Frequenzfolge, die untereinander einen vorgegebenen Phasenversatz aufweisen.

Das in Fig. 14 dargestellte schematische Blockdiagramm einer Vorrichtung zur Signalverarbeitung von zeitdiskreten Werten besitzt die Komponenten der Vorrichtung gemäß Fig. 13 und darüber hinaus zweite Mittel 26 zum Erzeugen von Abtastfrequenzen mit versetzter Phase, wobei diese zweiten Mittel 26 eine zweite Gruppe von abtastenden Mitteln 21.1, 21.2, ... beaufschlagen und diesen abtastenden Mitteln 21 die aufsummierten Signale der abtastenden Mittel 20 zugeführt werden. Die abtastenden Mittel 21 geben ihre Signale wiederum an zweite Mittel 31 zum Aufsummieren weiter, wobei diese die Signale dann wie bereits oben erwähnt weiteren Mitteln 40 zum Weiterver-/bearbeiten zugeführt werden.

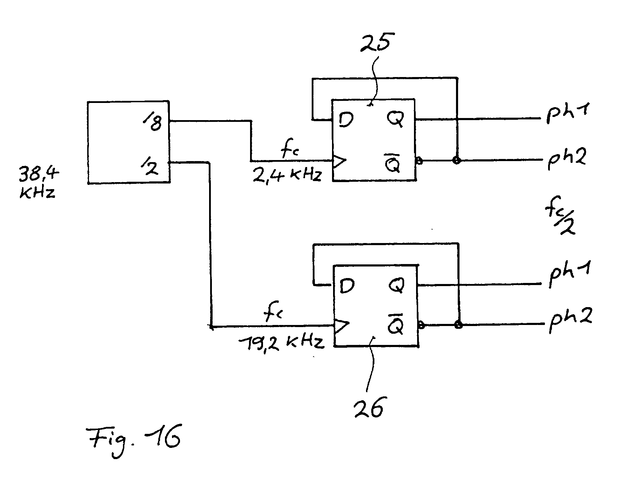

Die Vorrichtung gemäß Fig. 15 weist einen ähnlichen Aufbau auf wie die Vorrichtung gemäß Fig. 13, jedoch sind hier zweite Mittel 26 zum Erzeugen einer Abtastfrequenz mit Phasenversatz vorhanden, die parallel zu den abtastenden Mitteln 20 geschaltete weitere Mittel 21 beaufschlagen, wobei die Ausgangssignale der abtastenden Mittel 20 und der abtastenden Mittel 21 gemeinsam Mitteln 30 zum Summieren zugeführt werden.

Es ist auch möglich, daß mehreren Gruppen von abzutastenden Mitteln jeweils die gleiche Gruppe phasenversetzter Takte zugeführt wird.

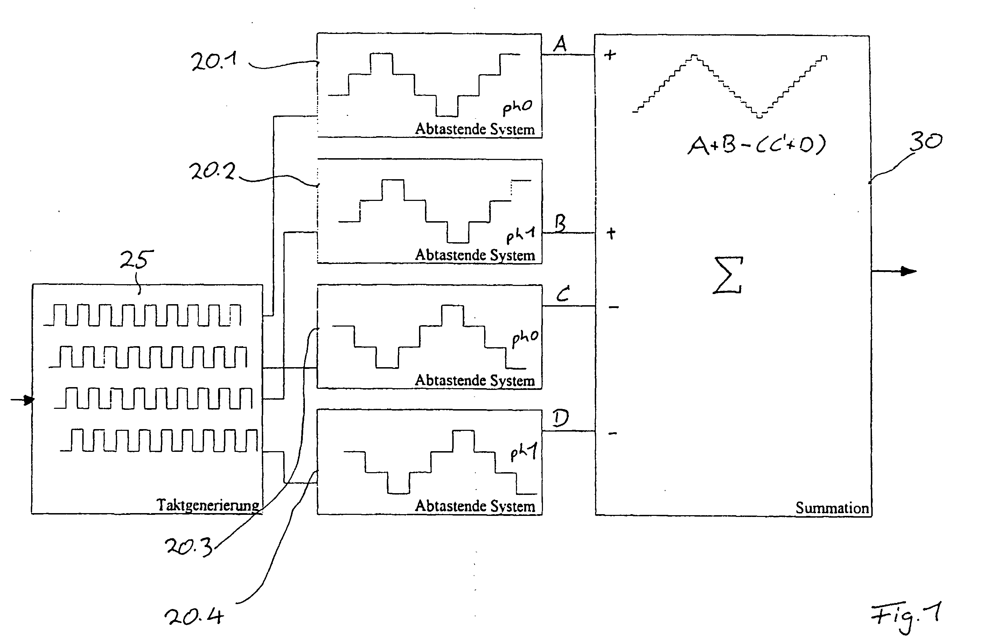

Fig. 1 zeigt eine Anordnung, bei der abtastende Mittel teilweise mit um 180° verschobenen Eingangssignalen beaufschlagt werden. Die dargestellte symmetrische Anordnung hat den zusätzlichen Vorteil, daß die Verzerrungen, die durch das abtastende Mittel entstehen, unterdrückt werden. Zwei abtastende Mittel 20.1, 20.2 erzeugen eine aus sechs gleichhohen Stufen bestehende Dreiecksspannung. Die anderen beiden abtastenden Mittel 20.3, 20.4 erzeugen das um 180° verschobene identische Signal. Die vier Mittel, 20.1, 20.2, 20.3, 20.4 werden mit der gleichen Frequenz, aber mit vier in der Phasenlage unterschiedlichen Takten über die Mittel 25 zum Taktgenerieren angesteuert. Die vorzeichenrichtige Summation der vier Ausgangssignale ergibt eine Dreiecksspannung mit jeweils vier Interpolationsstellen pro Schritt, d.h. die Dreiecksspannung wird nun aus 24 Stufen generiert. Das dargestellte Signal innerhalb der Mittel 30 zum Summieren der Ausgangssignale ist um den Faktor 4 kleiner angegeben, um einen besseren Vergleich zu ermöglichen. Die Fig. 1 zeigt deutlich, daß die Auflösung um den Faktor 4 gesteigert wurde, ohne die Auflösung des einzelnen abtastenden Systems und ohne die Abtastrate zu erhöhen.

Allgemein betreffen die nichtinvertierten und invertierten Signale die Eingangs- bzw. die sich ergebenden Ausgangs-signale der abtastenden Mittel. Die Summation der nichtinvertierten und Subtraktion der invertierten Signale bezieht sich auf die Ausgangssignale der abtastenden Systeme. So müßte zur Erzeugung von zusätzlichen invertierten Signalen mit Hilfe von Digital Analog Wandlern nur das digitale Eingangswort des jeweiligen Wandlers invertiert werden.

Wenn nur zwei abtastende Mittel parallel geschaltet sind, wäre die Abtastfrequenz um 180° verschoben (360° : 2 abtastende Mittel) . Das ist der einfachste Fall. Dabei bestimmt nur die Phasenlage des Eingangs- bzw. Ausgangssignal der abtastenden Mittel, ob summiert oder subtrahiert wird.

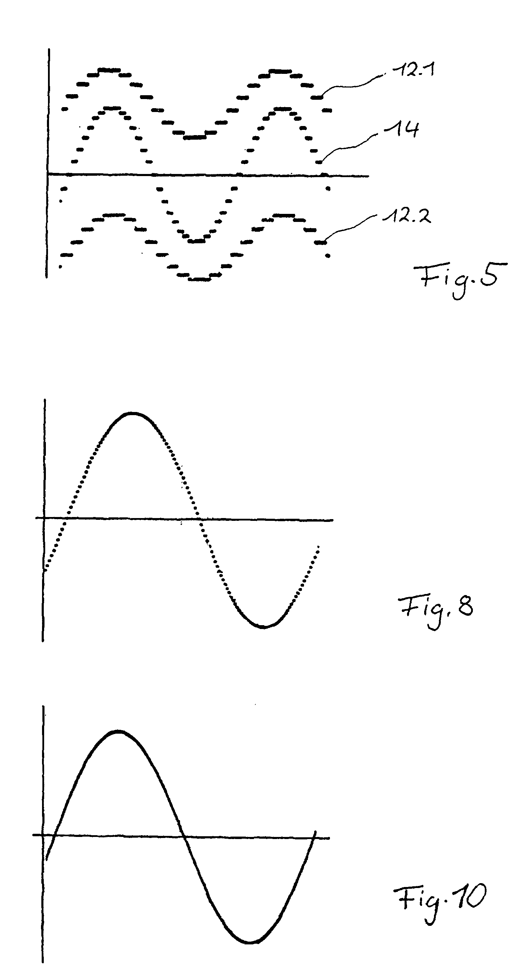

Ein weiteres Ausführungsbeispiel ist die Generierung von Sinusschwingungen. Im Unterschied zur Dreiecksspannung sind die Stufen unterschiedlich hoch. Im Nulldurchgang des Sinus sind die Änderungen am größten. Fig. 4 zeigt das Blockdiagramm einer möglichen Realisierung eines digitalen Sinusgenerators.

Der Taktgenerator 15 erzeugt einen Masterclock, aus dem alle anderen Takte abgeleitet werden.

Die beiden digitalen Sinusgeneratoren 20.1, 20.2 bestehen aus einer bekannten Anordnung mit bekanntem Aufbau. Beide Generatormodule 20 werden mit der gleichen Frequenz von 2400 Hz, aber mit um 180° verschobenen Takten angesteuert. Die resultierende Sinusfrequenz weist dementsprechend eine Frequenz von 2400 Hz/16 = 150 Hz auf. Die beiden Ausgangsamplituden werden in der nachfolgenden Summationsstufe aufsummiert. Fig. 5 zeigt die entsprechenden Oszillogramme. Die beiden 16-stufigen Sinusschwingungen 12.1, 12.2 sind um die halbe Taktlänge gegeneinander verschoben. In der Mitte ist die Sinusschwingung 14 als Summation beider Signale dargestellt. Es ist deutlich zu erkennen, daß das Summensignal 14 die doppelte Amplitude aufweist und doppelt so viele Stützstellen besitzt. Die unterschiedliche Höhe der Stufen ist ebenfalls erhalten geblieben.

In Fig. 6 ist die Spektralanalyse der 16-stufigen Sinusschwingung 12.1 zu sehen. Die dominierenden Spektralanteile sind die Grundwelle mit gewählten 150 Hz und die Faltungsprodukte der Grundwelle mit der nicht unterdrückten Abtastfrequenz (Abtastfrequenz - Grundwelle, Abtastfrequenz + Grundwelle) . Diese Produkte liegen 25 dB unter der Grundwelle, was ungefähr 2010g(1/16 Bit) = -24 dB entspricht.

Die Fig. 7 zeigt die Spektralanalyse der 32-stufigen Summation der Sinusschwingung 14. In dem dargestellten Verlauf dominieren ebenfalls die Spektralanteile der Grundwelle und die Faltungsprodukte der Grundwelle mit der nicht unterdrückten Abtastfrequenz (Abtastfrequenz - Grundwelle, Abtastfrequenz + Grundwelle). Der Unterschied ist, daß die dominierende Abtastfrequenz bei der doppelten Frequenz liegt im Vergleich zur Spektralanalyse gemäß Fig. 6 und daß die Amplitude um die Hälfte also 6 dB kleiner ist. Das entspricht ungefähr 20log(1/32 Bit) = -30 dB. Die zusätzlichen Spiegelprodukte entstehen, weil die Abtastfrequenz nicht unterdrückt wurde.

Die Signale der Sinusschwingung 14 gemäß Fig. 5 werden zwei Switched-Capacitor Filtern 21.1, 21.2 zugeführt, deren Eckfrequenz so gelegt ist, daß sie diese Spiegelprodukte unterdrücken. Die beiden Filter 21.1, 21.2 werden mit einer Frequenz von 19,2 kHz betrieben, so daß sich eine resultierende 3 dB Eckfrequenz von 19200/100 = 192 Hz aufgrund der hier gewählten Vorgaben ergibt. Ebenso wie beim Generator sind die beiden Takte gegeneinander um 180° verschoben und die beiden Ausgangssignale werden in Mitteln 31 zum Summieren aufsummiert.

Fig. 8 zeigt das Signal, wenn nur ein SC Tiefpaßfilter 21.1 verwendet wird. Die Abstufungen sind aufgrund der höheren Abtastrate mehr geworden, nämlich 19200/150 = 128. Die Spektralanalyse dieses Signals ist in Fig. 9 wiedergegeben. Außer der 150 Hz Grundwelle ist noch die 19,2 kHz Abtastfrequenz zu sehen. Diese ist 20log(19200/150) = -42 dB kleiner als die Grundwelle.

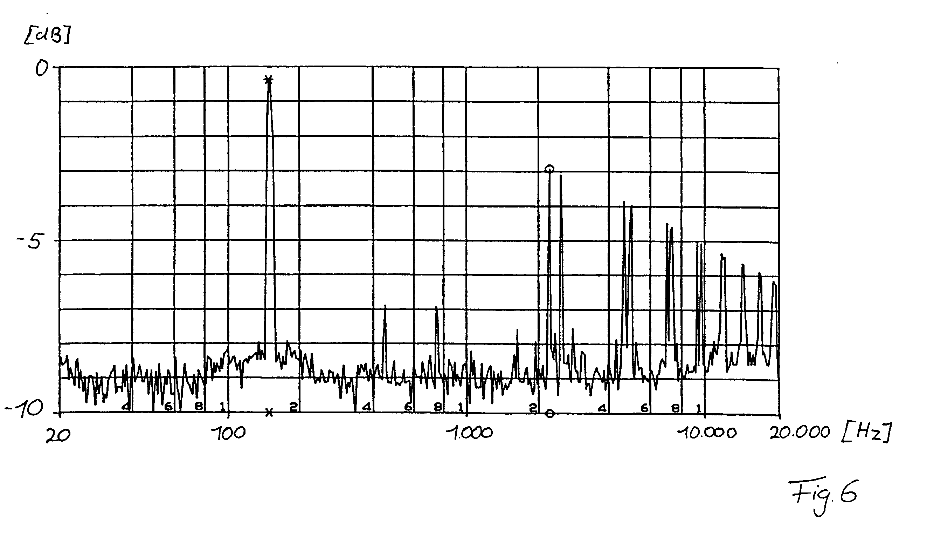

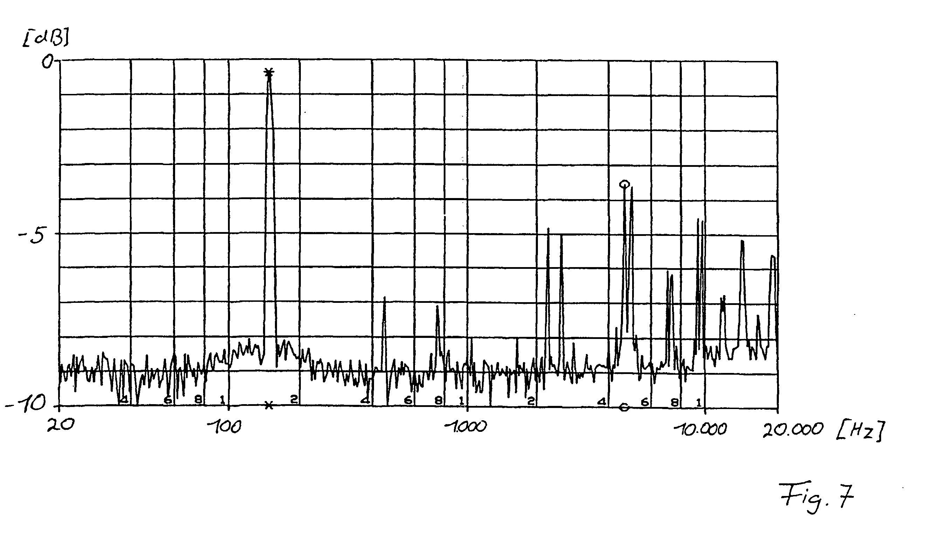

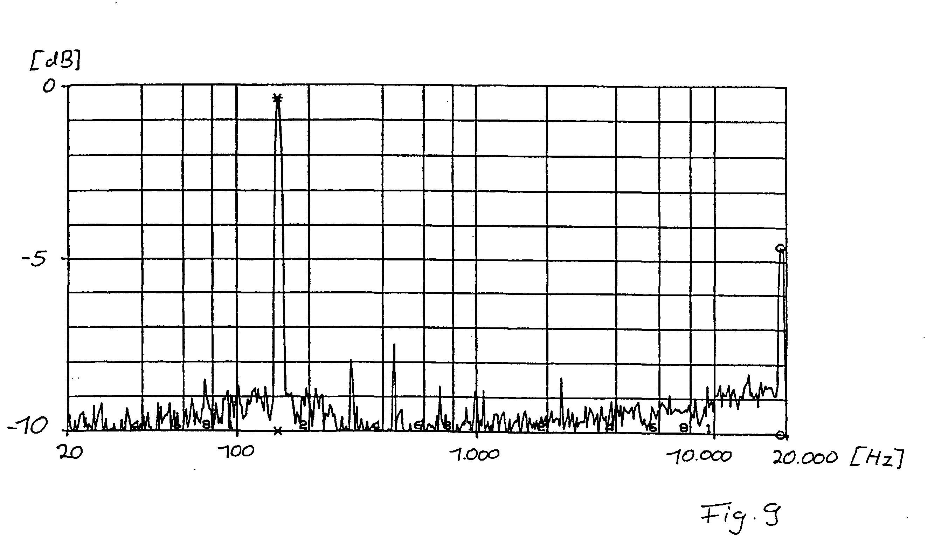

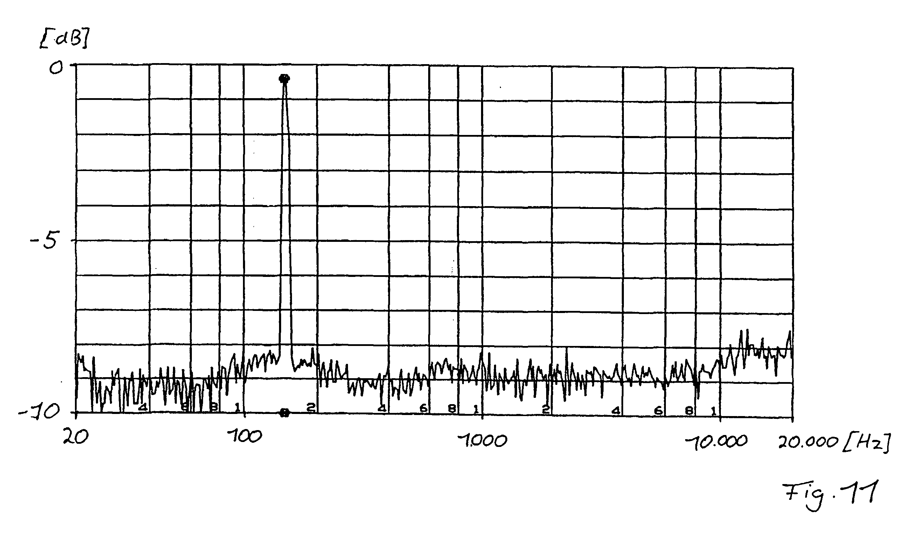

Bei der Verwendung von beiden Filtern 21.1, 21.2 ergibt sich eine Verdopplung der Stufen, wie sie in Fig. 10 dargestellt ist. Die Spektralanalyse dieses Signals ist in Fig. 11 dargestellt. In dieser Fig. ist nur noch die Grundwelle zu sehen, da die Spektralkomponenten der Abtastfrequenz außerhalb des Audiobandes von 20 kHz liegt, nämlich bei 38,4 kHz mit einer Amplitude von 20log(38400/150) = -48 dB.

Man erkennt also an dieser Anordnung, daß jedes zusätzliche in dieser Art parallel geschaltete Mittel einen Zwischenwert bringt, d.h. zwei parallel geschaltete Mittel, die mit einem 0° und mit einem um 180° verschobenen Takt der gleichen Frequenz angesteuert werden, erzeugen eine Frequenzkomponente, die in der Frequenz um den Faktor 2 höher liegt und in der Amplitude um den Faktor 2 kleiner ist als die ursprüngliche Frequenzkomponente.

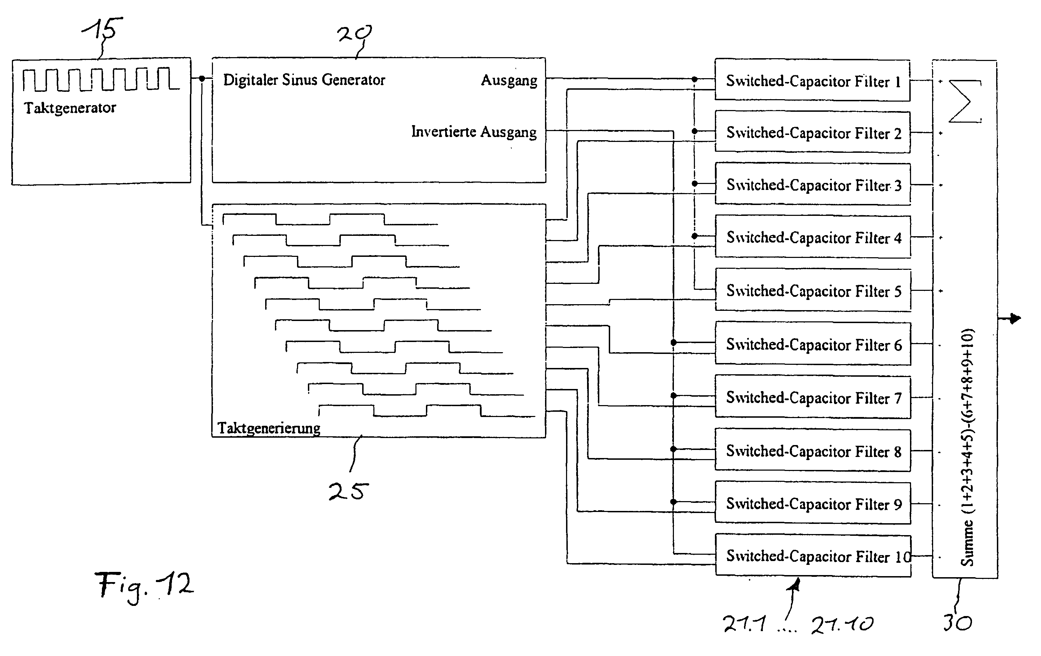

Um eine Filterung über den gesamten Audiobereich mit SC-Filtern zu realisieren, ohne die Eckfrequenz des nachfolgenden analog zeitkontinuierlichen Filters umzuschalten, muß die resultierende Spektralkomponente außerhalb der 20 kHz liegen. Realisieren läßt sich dieses durch die Parallelschaltung von zehn SC-Filtern, unter der Annahme, daß die 3 dB Eckfrequenz um den Faktor 100 geringer ist als die Abtastfrequenz. Die zehn Takte für die Filter sind dann jeweils um 36° verschoben. Fig. 12 zeigt eine derartige Anordnung. Diese Anordnung weist zwei Gruppen von jeweils fünf SC-Filtern 21.1 bis 21.10 auf. Die Gruppen werden mit um 180° verschobenen Eingangssignalen beaufschlagt (Ausgang und invertierter Ausgang des digitalen Sinusgenerators 20), so daß sich die in beiden Gruppen entstandenen Verzerrungen bei der vorzeichenrichtigen Summation zusätzlich aufheben.

Der wichtigste Teil ist die Bereitstellung des Taktes für die SC-Filter 21.1 bis 21.10. Wie man aus der Darstellung der Mittel 25 zur Taktgenerierung erkennt, haben alle Takte die gleiche Frequenz, aber eine unterschiedliche Phasenlage zueinander.

Der schlechteste Fall ist die Generierung des 20 Hz Sinussignals, da dann die Spektralkomponente der Abtastfrequenz am dichtesten am oberen Audioband liegt. Unter der Annahme, daß die Eckfrequenz des SC Tiefpaßfilters bei der 1,28-fachen Frequenz gemäß der zu filternden Grundwelle bei dem vorliegenden Ausführungsbeispiel liegt, ergibt sich eine Abtastkomponente von 20 Hz x1,28x10x100 = 25,6 kHz mit einer Amplitude von 201og(20xl,28x100x10/20) = -62 dB. Diese Spektralkomponente liegt also in der Frequenz um den Faktor 10 höher und ist in der Amplitude um den Faktor 10 (-20 dB) kleiner als die Komponente eines jeden einzelnen SC-Filters. Eine solche Komponente läßt sich leicht durch ein nachfolgendes zeitkontinuierliches Filter, dessen Aufbau bekannt ist, unterdrücken.

Wie dargestellt kann das Mittel mit festen Frequenzen arbeiten, beispielsweise für den CD-Bereich mit 44,1 kHz, für den Tape-Bereich mit 48 kHz oder für den Video-Bereich mit 13,5 MHz, weil sich obige Figuren beispielhaft auf digitale Audiosysteme beziehen.

Ebenso läßt sich jedoch die erfindungsgemäße Vorrichtung auch mit variablen Frequenzen einsetzen, wie sie bei durchstimmbaren SC-Filtern vorkommen.

Ein weiterer Vorteil, der sich aus der Parallelschaltung der abtastenden Mittel ergibt, ist die Verringerung des Rauschens, denn während sich die Ausgangsamplitude des Nutz-signals verdoppelt, vergrößert sich die Rauschspannung bei nicht korrelierenden Mitteln nur um Wurzel aus 2.

## Patentansprüche

1. Vorrichtung zur Signalverarbeitung von zeitdiskreten Werten für signalabtastende Systeme mit Mitteln (20; 21) wie Digital Analog Wandlern, Switched-Capacitor Filtern, Direkt Digital Synthesizern, Sample- and Hold-Schaltungen und dergleichen, die ein analoges zeitdiskretes Ausgangssignal liefern, mit
- Mitteln zum Erzeugen zeitdiskreter Werte, die den Mitteln (20; 21) zugeführt werden, die ein analoges zeitdiskretes Ausgangssignal liefern,
- zumindest einer Gruppe von zumindest zwei parallel geschalteten signalabtastenden Mitteln (20; 21),
- Mitteln (25) zum Erzeugen von Abtastsignalen gleicher Frequenz,
- Summationsmitteln (30), die die Ausgangssignale der signalabtastenden Mittel (20; 21) aufsummieren,
**dadurch gekennzeichnet, daß**
bei der zumindest einen Gruppe von zumindest zwei signalabtastenden parallel geschalteten Mitteln (20; 21) jeweils eine Signalabtastung des betragsmäßig gleichen Eingangssignals durchgeführt wird und
- das jeweilige abtastende Mittel (20; 21) mit versetzter Phasenlage der Abtastsignale von den Mitteln (25) zum Erzeugen von Abtastsignalen gleicher Frequenz angesteuert wird,
- wodurch zu jedem Eingangssignal mehrere entsprechend der Anzahl der parallel geschalteten signalabtastenden Mittel (20; 21) gleiche aber phasenversetzte analoge Ausgangssignale erzeugt werden, die durch ihre Summation eine Interpolation im analogen Bereich darstellen.

2. Vorrichtung nach Anspruch 1,
**dadurch gekennzeichnet, daß**
die Anzahl der parallel geschalteten abtastenden Systeme (20; 21) der Anzahl der Abtastsignale gleicher Frequenz mit versetzter Phasenlage entspricht.

3. Vorrichtung nach Anspruch 1 oder 2,
**dadurch gekennzeichnet, daß**
n Abtastsignale um je 360°/n phasenverschoben erzeugt werden, wobei n der Anzahl der parallel geschalteten abtastenden Mittel (20; 21) entspricht, das heißt eine lineare Interpolation möglich ist.

4. Vorrichtung nach Anspruch 1 und/oder 2,
**dadurch gekennzeichnet, daß**
bei Abtastsignalen gleicher Frequenz die Phasenunterschiede der Abtastfrequenzen mit versetzter Phasenlage unterschiedlich ausgebildet sind, das heißt eine nicht lineare Interpolation möglich ist.

5. Vorrichtung nach Anspruch 1 oder 2,
**dadurch gekennzeichnet, daß**
die parallel geschalteten abtastenden Mittel bei Abtastsignalen gleicher Frequenz mit Abtastfrequenzen mit versetzter Phasenlage (25) angesteuert werden und mit nichtinvertierten (20.1 und 20.2) und invertierten (20.3 und 20.4) Eingangssignalen beaufschlagt werden und die Mittel zum Summieren der Signale (30) die nichtinvertierten Signale aufsummieren und die invertierten Signale abziehen.

6. Vorrichtung nach Anspruch 1 oder 2,
**dadurch gekennzeichnet, daß**
die Anzahl der erzeugten Abtastfrequenzen bei Abtastsignalen gleicher Frequenz mit versetzter Phasenlage der Anzahl der Interpolationsstellen der abtastenden Mittel entspricht.

7. Vorrichtung nach Anspruch 1,
**dadurch gekennzeichnet, daß**
zumindest zwei abtastende Mittel gleich ausgebildet sind.

8. Vorrichtung nach Anspruch 1,
**dadurch gekennzeichnet, daß**
mehrere Gruppen von abzutastenden Mitteln (20; 21) vorhanden sind, wobei jede Gruppe mit unterschiedlichen Abtastfrequenzen mit versetzter Phasenlage angesteuert wird.

9. Vorrichtung nach Anspruch 08,
**dadurch gekennzeichnet, daß**
die Signale der mehreren Gruppen von abtastenden Mitteln einem Mittel (30) zum Aufsummieren zugeführt werden.

10. Vorrichtung nach Anspruch 08,
**dadurch gekennzeichnet, daß**
die aufsummierten Signale der ersten Gruppe von abtastenden Mitteln (20.1, 20.2, ...) einer zweiten Gruppe von abtastenden Mitteln (21.1, 21.2, ...) zugeführt werden, die wiederum über weitere Mittel (26) zum Erzeugen von Abtastfrequenzen bei Abtastsignalen gleicher Frequenz mit versetzter Phasenlage angesteuert werden und deren Signale weiteren Mitteln (31) zum Aufsummieren zugeführt werden.

11. Vorrichtung nach einem oder mehreren der vorstehenden Ansprüche 1 bis 7 und 9, 10,
**dadurch gekennzeichnet, daß**
mehrere Gruppen von abzutastenden Mitteln (20; 21) vorhanden sind, wobei jede Gruppe mit gleichen Abtastfrequenzen mit versetzter Phasenlage angesteuert wird.

## Claims

1. Apparatus for signal processing discrete-time values for signal-sampling systems having means (20; 21), such as digital/analog converters, switched capacitor filters, direct digital synthesizers, sample-and-hold circuits and the like, which deliver an analog discrete-time output signal, having
- means for producing discrete-time values, which are supplied to the means (20; 21) delivering an analog discrete-time output signal,
- at least one group of at least two parallel-connected signal-sampling means (20; 21),
- means (25) for producing sampling signals at the same frequency,
- summation means (30) which sum the output signals from the signal-sampling means (20; 21),
**characterized in that**,
in the at least one group of at least two signal-sampling parallel-connected means (20; 21), signal sampling is in each case carried out on the input signal, which is identical in terms of magnitude, and
- the respective sampling means (20; 21) is driven by the means (25) for producing sampling signals at the same frequency using a shifted phase angle for the sampling signals,
- the result of which is that, for each input signal, a plurality of analog output signals are produced which are identical but phase-shifted on the basis of the number of parallel-connected signal-sampling means (20; 21), the summation of said output signals representing interpolation in the analog domain.

2. Apparatus according to Claim 1,
**characterized in that**
the number of parallel-connected sampling systems (20; 21) is equivalent to the number of sampling signals at the same frequency with a shifted phase angle.

3. Apparatus according to Claim 1 or 2,
**characterized in that**
n sampling signals each phase-shifted through 360°/n are produced, where n corresponds to the number of parallel-connected sampling means (20; 21), that is to say that linear interpolation is possible.

4. Apparatus according to Claim 1 and/or 2,
**characterized in that**,
in the case of sampling signals at the same frequency, the phase differences of the sampling frequencies with a shifted phase angle are different, that is to say that nonlinear interpolation is possible.

5. Apparatus according to Claim 1 or 2,
**characterized in that**,
in the case of sampling signals at the same frequency, the parallel-connected sampling means are driven using sampling frequencies with a shifted phase angle (25) and have uninverted (20.1 and 20.2) and inverted (20.3 and 20.4) input signals applied to them, and the means for summing the signals (30) sum the uninverted signals and deduct the inverted signals.

6. Apparatus according to Claim 1 or 2,
**characterized in that**,
in the case of sampling signals at the same frequency, the number of sampling frequencies produced with a shifted phase angle is equivalent to the number of interpolation points for the sampling means.

7. Apparatus according to Claim 1,
**characterized in that**
at least two sampling means are identical.

8. Apparatus according to Claim 1,
**characterized in that**
a plurality of groups of means (20; 21) which are to be sampled are provided, each group being driven using different sampling frequencies with a shifted phase angle.

9. Apparatus according to Claim 08,
**characterized in that**
the signals from the plurality of groups of sampling means are supplied to a summing means (30).

10. Apparatus according to Claim 08,
**characterized in that**
the summed signals from the first group of sampling means (20.1, 20.2, ...) are supplied to a second group of sampling means (21.1, 21.2, ...), which, in turn, are driven via further means (26) for producing sampling frequencies, in the case of sampling signals at the same frequency, using sampling frequencies with a shifted phase angle and whose signals are supplied to further summing means (31).

11. Apparatus according to one or more of the preceding Claims 1 to 7 and 9, 10,
**characterized in that**
a plurality of groups of means (20; 21) which are to be sampled are provided, each group being driven using identical sampling frequencies with a shifted phase angle.

## Revendications

1. Dispositif pour le traitement de signaux de valeurs discrètes dans le temps pour des systèmes d'échantillonnage avec des moyens (20 ; 21) tels que des convertisseurs numériques-analogiques, des filtres à capacités commutées, des synthétiseurs directs numériques, des circuits d'échantillonnage et de maintien et similaires, qui fournissent un signal de sortie analogique et discret dans le temps, avec
- des moyens pour générer des valeurs discrètes dans le temps, qui sont amenés aux moyens (20 ; 21), lesquels fournissent un signal de sortie analogique et discret dans le temps,
- au moins un groupe d'au moins deux moyens (20 ; 21) d'échantillonnage montés en parallèle,
- des moyens (25) pour générer des signaux d'échantillonnage de même fréquence,
- des moyens de sommation (30), qui additionnent les signaux de sortie des moyens d'échantillonnage (20 ; 21),
**caractérisé en ce que**, sur au moins un groupe d'au moins deux moyens (20 ; 21) d'échantillonnage branchés en parallèle, respectivement une exploration du signal d'entrée identique au niveau de la valeur est effectuée et
- le moyen (20 ; 21) d'échantillonnage concerné est commandé avec une position de phase décalée des signaux d'échantillonnage par les moyens (25) destinés à générer des signaux d'échantillonnage de même fréquence,
- moyennant quoi, pour chaque signal d'entrée, on génère plusieurs signaux de sortie analogiques identiques, mais déphasés en fonction du nombre des moyens (20 ; 21) d'échantillonnage branchés en parallèle, qui représentent du fait de leur sommation une interpolation dans la plage analogique.

2. Dispositif selon la revendication 1, **caractérisé en ce que** le nombre des systèmes d'échantillonnage (20 ; 21) branchés en parallèle correspond au nombre des signaux d'échantillonnage de même fréquence avec une position de phase décalée.

3. Dispositif selon la revendication 1 ou 2, **caractérisé en ce que** n signaux d'échantillonnage sont générés avec un déphasage de 360°/n chacun, n correspondant au nombre des moyens (20 ; 21) d'échantillonnage branchés en parallèle, ce qui veut dire qu'une interpolation linéaire est possible.

4. Dispositif selon la revendication 1 et/ou 2, **caractérisé en ce que**, pour des signaux d'échantillonnage de même fréquence, les déphasages des fréquences d'échantillonnage sont conçus différents avec une position de phase décalée, ce qui veut dire qu'une interpolation non linéaire est possible.

5. Dispositif selon la revendication 1 ou 2, **caractérisé en ce que** les moyens d'échantillonnage branchés en parallèle sont commandés dans le cas de signaux d'échantillonnage de même fréquence avec des fréquences d'échantillonnage avec une position de phase décalée (25) et sont alimentés avec des signaux d'entrée non inversés (20.1 et 20.2) et inversés (20.3 et 20.4) et les moyens destinés à la sommation des signaux (30) additionnent les signaux non inversés et soustraient les signaux inversés.

6. Dispositif selon la revendication 1 ou 2, **caractérisé en ce que** le nombre des fréquences d'échantillonnage générées correspond au nombre des points d'interpolation des moyens d'échantillonnage dans le cas de signaux d'échantillonnage de même fréquence avec une position de phase décalée.

7. Dispositif selon la revendication 1, **caractérisé en ce qu'**au moins deux moyens d'échantillonnage sont de conception identique.

8. Dispositif selon la revendication 1, **caractérisé en ce que** plusieurs groupes de moyens (20 ; 21) d'échantillonnage sont disponibles, chaque groupe étant commandé avec des fréquences d'échantillonnage différentes avec une position de phase décalée.

9. Dispositif selon la revendication 8, **caractérisé en ce que** les signaux des quelques groupes de moyens d'échantillonnage sont amenés à un moyen (30) destiné à la sommation.

10. Dispositif selon la revendication 8 **caractérisé en ce que** les signaux additionnés du premier groupe de moyens d'échantillonnage (20.1, 20.2, ...) sont amenés à un deuxième groupe de moyens d'échantillonnage (21.1, 21.2, ...), qui sont commandés à leur tour par d'autres moyens (26) destinés à générer des fréquences d'échantillonnage dans le cas de signaux d'échantillonnage de même fréquence avec une position de phase décalée et dont les signaux sont amenés à d'autres moyens (31) destinés à la sommation.

11. Dispositif selon l'une quelconque ou plusieurs des revendications précédentes 1 à 7 et 9, 10, **caractérisé en ce que** plusieurs groupes de moyens d'échantillonnage (20 ; 21) sont disponibles, chaque groupe étant commandé avec des fréquences d'échantillonnage identiques avec une position de phase décalée.
